# EUROPEAN PATENT APPLICATION

(11) **EP 0 877 417 A1**
(43) Date of publication of application: **11.11.1998**
(21) Application number: 98303294.7
(22) Date of filing: 28.04.1998
(51) Int. Cl.: H01L 21/28, H01L 21/60

(54) **Method for fabrication of electrodes and other electrically-conductive structures**

(30) Priority: 09.05.1997 US 853584
(71) Applicant: LUCENT TECHNOLOGIES INC., Murray Hill, New Jersey 07974-0636 (US)
(72) Inventor: Sneh, Ofer, Branchburg, New Jersey 08876 (US); Moser, David T., New Tropoli, Pennsylvania 18066 (US); Voyden, Leo J., Allentown, Pensylvania 18103 (US); Smith, Craig Gordon, Trexlertown, Pennsylvania 18087 (US); Wysock, Stephen John, Denver, Pennsylvania 17517 (US)
(74) Representative: Johnston, Kenneth Graham

(57) **Abstract**

Embodiments of the invention include a method for fabricating metal structures such as electrodes on a substrate. Typical fabrication methods of this kind include depositing a seed layer on a substrate, depositing a photoresist on the seed layer, patterning the photoresist, forming the metal structure according to the patterned photoresist using electroplating techniques, and then removing the photoresist to yield the metal structure. However, underplating often occurs during electroplating, and the hard baking requirements for treating the photoresist cause photoresist deformation that is translated into deformed structures. Embodiments of the invention deposit a sacrificial layer on the substrate's seed layer to promote greater adhesion between the seed layer and the subsequently deposited photoresist layer. The sacrificial layer, which includes titanium or other suitable material, improves adhesion between the seed layer and the photoresist to the extent that the photoresist hardbaking requirement is eliminated and the underplating contributions caused by layer separation are suppressed. Also, the sacrificial layer is made of a material that is unsuitable for electroplating metal materials thereon, thus discouraging metal materials from electroplating to exposed regions in the event that some layer separation does occur.

## Description

### Background of the Invention

### 1. Field of the Invention

The invention relates to photolithographic processing. More particularly, the invention relates to the fabrication of electrodes and other electrically-conductive structures using photolithographic techniques.

### 2. Description of the Related Art

Metallic layers or electrically-conductive layers are used commonly in microelectronics and electro-optics technologies to facilitate the formation of electrodes and electrical contacts. While thin metallic films (e.g., films having a thickness less than a 1-5 µm) typically are deposited using physical vapor deposition (PVD) or chemical vapor deposition (CVD) techniques, thicker films (e.g., films having a thickness greater than approximately 10 µm) typically are obtained via electroplating. Thick metallic structures whose width (W) is greater than its thickness (T) (i.e., whose aspect ratio W/T is greater than 1.0) are obtained, e.g., by electroplating the metal into patterned photoresist structures.

In conventional metallic layer formation processing techniques, a thin seed layer (e.g., gold) is deposited on the substrate surface using, e.g., PVD methods. Next, a thick photoresist coating is applied and patterned using conventional photolithography techniques, thus exposing the seed layer accordingly. The photoresist thickness typically is somewhat greater than the final desired thickness of the metal structure. Next, electroplating will deposit metal on the exposed seed layer surfaces and cause the metallic structure to grow while being bounded and shaped by the openings in the photoresist film. Typically, the metallic pattern will reproduce the shape of the openings in the photoresist template.

Photolithography for thick plated metal (e.g., >10 pm) has several constraints. First, photoresist thickness typically is kept at a minimum to maximize resolution. Second, depth variations in exposure intensity due to absorption and imaging focal depth become more pronounced as the photoresist thickness is increased. Also, the photoresist must survive the electroplating chemistry. However, despite these constraints, the photoresist image should produce a template used to produce the desired metallic structure.

In typical photolithography processes, the photoresist is applied on the wafer area using spin coating. Following the photoresist coating, a pre-develop bake is used to remove excess solvent from the photoresist film. The film is then exposed to UV light using masking techniques. During a wet develop process, a pattern is delineated. The photoresist is then treated with a post-develop bake (PDB) to obtain consistent results through the electroplating process. The PDB enhances polymerization and crosslinking of photoresist material and destroys the light-sensitive sensitizer molecules. However, PDB also induces significant deformation of the photoresist edge profile that, when used as electroplating templates, translates into a similar profile of the plated metal.

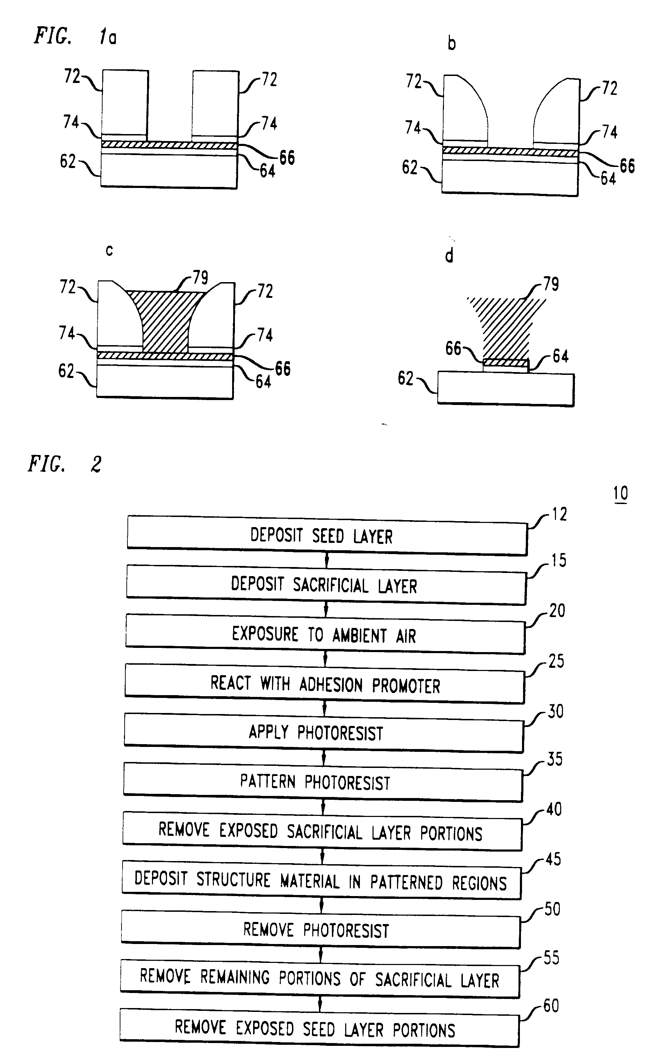

The deformation associated with the post-develop bake (PDB) is disadvantageous, especially for fabrication of high aspect ratio structures. For example, when using a photoresist having a thickness of approximately 13 µm, a desired opening of 8 µm could taper out to approximately 14-15 µm from the substrate surface to the top of the photoresist (e.g., see Figs. 1a-b). Moreover, the photoresist flow is translated directly into tapered metallic structures (e.g., see Figs. 1c-d), which typically have disadvantageous performance characteristics and poor reproducibility. Additionally, such photoresist tapering causes strong thickness dependence of the lateral dimensions of the metallic structure features, thus affecting the consistency of the plated metallic structures. Another undesirable property of metallic shapes that are often plated into hard-baked photoresist structures is the irregularity of the metallic structures corners, which is caused by the appreciable surface roughness. More specifically, the roughness is parallel to the photoresist walls and has a lateral component if the walls are tapered, causing rough edges.

Several approaches are reported to address the deformation and associated problems mentioned above. For example, techniques such as UV or plasma curing prior to the PDB step to stabilize the photoresist profile are disclosed. See, e.g., U.S. Pat. No. 5,407,787, issued to McElhanon et al., in which plasma curing was suggested as a substitute for PDB.

Other approaches include post exposure (pre-develop) bake (PEB) and higher soft-bake temperatures. However, in general, such approaches yields poor results. For example, the photoresist is chemically attacked by the electroplating bath solution, resulting in some removal of photoresist material and subsequent Au electroplating under the photoresist film (underplating).

In some extreme cases, this underplating results in breakage of photoresist pieces from the seed film, especially from relatively narrow photoresist features. Conventional approaches to suppression of underplating include the use of lower electroplating current densities during the electroplating of the first micron (probably because the first micron of plated Au could seal the Au-photoresist interface and therefore suppressed further contact with the electroplating solution). However, a total elimination of underplating, on a consistent basis, by lowering the initial current density is not likely (probably due to the constantly changing concentrations of reactants in the electroplating bath).

Also, modification of the chemical parameters of the electroplating solution does not adequately reduce underplating. Although some limited success in suppressing underplating is possible by adjusting the solution composition, the electroplating process consumes the bath reagents and constantly changes the bath composition. As a result, the delicate chemical balance required to suppress underplating often is incapable of being maintained. Moreover, most correlations between underplating and the chemical parameters of the solution are conflicting and non-reproducible.

Therefore, a method for fabricating high aspect ratio structures is desired in which the foregoing problems are satisfactorily reduced or eliminated, including the undesirable effects of underplating under the (constantly changing) electroplating conditions.

### Summary of the Invention

The invention is embodied in a method for fabricating electrically-conductive structures such as electrodes on a substrate. Typical fabrication methods of this kind include depositing a seed layer on a substrate, depositing a photoresist on the seed layer, patterning the photoresist, forming the electrically-conductive structure according to the patterned photoresist using electroplating techniques, and then removing the photoresist to yield the electrically-conductive structure. However, underplating often occurs during electroplating, and the hard baking requirements for treating the photoresist cause photoresist deformation that is translated into deformed structures. Embodiments of the invention deposit a sacrificial layer on the substrate's seed layer to promote greater adhesion between the seed layer and the subsequently deposited photoresist layer. The sacrificial layer, which includes titanium or other suitable material, improves adhesion between the seed layer and the photoresist to the extent that the photoresist hardbaking requirement is eliminated and the underplating contributions caused by layer separation are suppressed. Also, the sacrificial layer is made of a material that is unsuitable for electroplating electrically-conductive materials thereon, thus discouraging electrically-conductive materials from electroplating to exposed regions in the event that some layer separation does occur.

### Brief Description of the Drawings

In the drawings:
Figs. 1a-d are partial cross-sectional side views of a structure fabricated according to conventional processes showing tapering deformation;
Fig. 2 is a simplified block diagram of a fabrication process according to embodiments of the invention;
Fig. 3a-k are partial cross-sectional side views of a structure fabricated according to embodiments of the invention; and
Fig. 4 are partial cross-sectional side views of a structure fabricated according to conventional processes and wherein underplating occurs.

### Detailed Description

In the following description like components are referred to by the same reference numeral in order to simplify the sequential aspect of the drawings.

Although specific features, configurations and arrangements are discussed hereinbelow, it should be understood that this is done for illustrative purposes only. A person skilled in the relevant art will recognize other steps, configurations and arrangements can be used without departing from the spirit and scope of the invention.

Embodiments of the invention are based on the realization that many of the problems associated with conventional processes for fabricating thick structures are the result of photoresist deformation and underplating. Further investigation in accordance with embodiments of the invention has revealed that soft-baking and hard-baking of the photoresist impact structural deformation of the photoresist and underplating. Furthermore, electroplating solutions are found to cause the slight dissolution of the photoresist. The interface between the seed film layer and the photoresist is weakened by the chemical attack of the electroplating solution, thus exposing some of the seed layer surface underneath the photoresist. Consequently, the surface of the exposed seed layer is plated and the growing film pushes the photoresist further away from the surface, thereby exposing more area and aggravating the problem.

However, as will be discussed in greater detail hereinbelow, embodiments of the invention employ a sacrificial layer (e.g., titanium) that improves the adhesion between the seed layer and the photoresist to the extent that the need for baking the photoresist is eliminated and the tendency of underplating to develop as a result of exposure to electroplating solutions is suppressed. Moreover, the sacrificial layer and/or its top surface is not conductive and therefore does not tend to be plated, thus allowing further suppression of underplating.

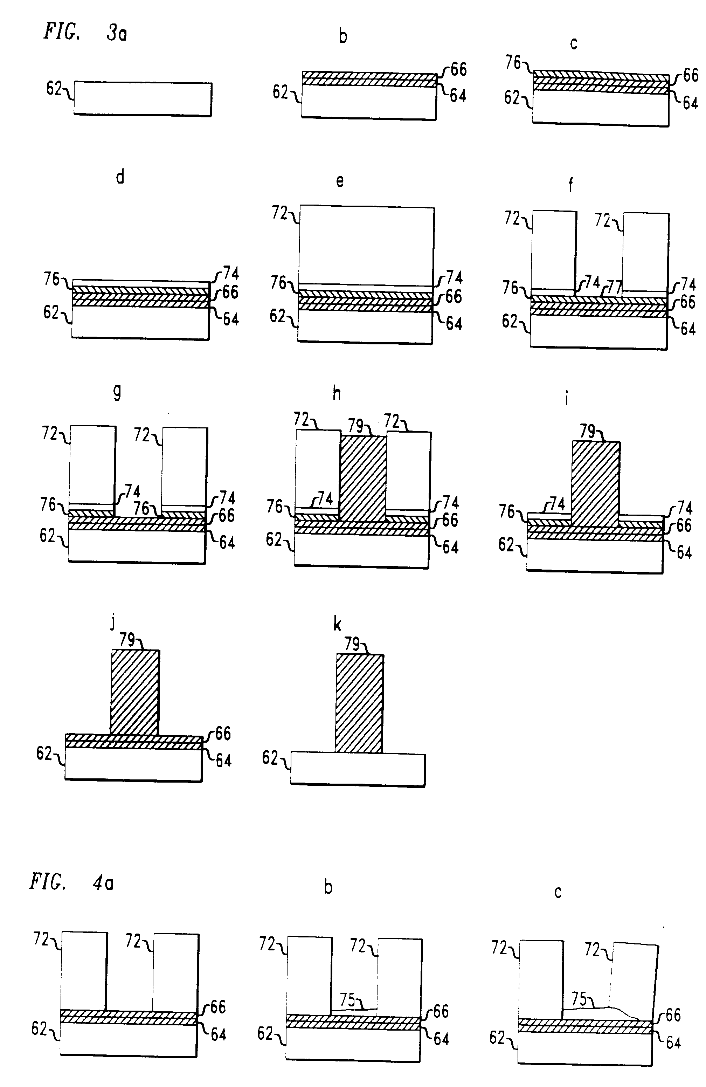

Referring now to Fig. 2, a simplified diagram of the steps of a fabrication method 10 according to embodiments of the invention is shown. Also, Figs. 3a-k depict sequentially the results of the inventive fabrication method from a cross-sectional side view. A first step 12 includes depositing a seed layer 62 onto a substrate 64 (see Figs. 3a-b). Seed layer 62 includes, e.g., a layer of gold (Au) or other suitable material deposited by vacuum evaporation or other conventional technique on a substrate such as silicon, quartz, lithium niobate or other suitable material. According to an alternative embodiment of the invention, an adhesion layer 66, such as chromium (Cr) or other suitable material is deposited on substrate 64, prior to seed layer 62, to enhance the adhesion of seed layer 62 to substrate 64.

The next step, conventionally, is to apply the photoresist (shown as 72 in the Figs.) to the seed layer 62 (shown as step 30 in Fig. 2). The photoresist is deposited, e.g., by spin coating or other suitable method. However, embodiments of the invention have recognized that the adhesion of the photoresist to the gold seed layer is a weakness to the overall fabrication process. Because gold is chemically inert, it does not adhere well to most materials, and in particular to organic polymer materials, such as photoresists. Therefore, it is not surprising that the minor dissolving power of the electroplating solutions, as mentioned hereinabove, can detach the loosely bonded photoresist from the surface of the gold seed layer. Some adhesion promoters, such as MS 802 by MicroSi Inc. of Phoenix, Arizona, may provide limited improvement.

However, as discussed previously herein, once the surface of the seed layer is exposed, underplating occurs if there is a reasonable transport of fresh electroplating solution to the area. In this manner, as shown in Figs. 4a-c, the growing gold layer 75 will then mechanically push the disconnected photoresist away from the surface, aggravating the problem.

Embodiments of the invention have advantageously modified the conventional method to suppress the tendency for underplating to occur. According to embodiments of the invention, an additional layer, i.e., a sacrificial layer, is deposited (e.g., by PVD or spin coating) on seed layer 62. For example, as shown in Fig. 3c, a sacrificial layer 76 of titanium (Ti), e.g., within the range from approximately 200 to approximately 700 Angstroms, is deposited on seed layer 62 by vacuum evaporation or other suitable deposition technique. Such deposition step is shown in Fig. 2 as step 15.

The titanium sacrificial layer 76 oxidizes readily upon exposure to the ambient air. Therefore, an exposure step 20 causes sacrificial layer 76 to grow thereon, e.g., a 15 Å layer 74 of native oxide - TiO₂ film (see Fig. 3d). For example, under the typical 40% humidity conditions of a cleanroom, this oxidation is completed within approximately 1-10 minutes. To expedite the oxidation and verify its completion, the titanium coated wafers are immersed in room temperature deionized (DI) water for approximately 15 minutes. Following this oxidation, the top surface of the sacrificial layer is believed to be a hydroxyl-terminated TiO₂ surface.

Although titanium is discussed as a possible use for sacrificial layer 76, sacrificial layer 76 is not limited to metallic layers having native oxide surfaces. Sacrificial layer 76 should be a layer that provides adequate adhesion to seed layer 62, with or without intermediate adhesion layers. Therefore, although sacrificial layers of, e.g., silicon, silicides and oxides are not advantageous when applied directly to, e.g., a gold seed layer 62, they can be used in conjunction with one or more suitable adhesion layers between the seed layer 62 and the sacrificial layer 76.

Then, according to an alternative embodiment of the invention, the surface is then reacted (shown as step 25) with an adhesion promoter such as hexamethyldisilizane (HMDS). HMDS is a conventional adhesion promoter that is capable of mediating a chemical bond, e.g., between oxide surfaces and photoresist materials.

As will be discussed in greater detail hereinbelow, the use of sacrificial layer 76 with or without an adhesion promoter provides an intermediate layer that provides greater adhesion between substrate 64 and photoresist 72. Such adhesion reduces the tendency for underplating to occur in subsequent processing steps, namely electroplating.

Referring again to fabrication method 10, photoresist 72 is deposited as shown in Fig. 3e. The deposition step (shown as step 30 in Fig. 2) is achieved by spin coating or other appropriate technique. However, accordingly to embodiments of the invention, unlike conventional fabrication processes of this kind, a significantly greater adhesion between photoresist 72 and substrate 64 is obtained from the relatively strong chemical bond of the TiO₂-HMDS layer 74 to both substrate 64 and photoresist 72.

In the next step (i.e., step 35), photoresist 72 is patterned according to conventional photolithographic patterning techniques. For example, photoresist 72 is deposited on sacrificial layer 76 and the excess solvent is removed, e.g., by evaporation via a pre-bake or pre-exposure bake (also referred to as a "soft bake"). A typical pre-bake involves a temperature between approximately 90-115 °C and a heating duration between approximately 45-60 seconds when a conventional hot plate is used. After the pre-bake, a photolithographic mask having a desired pattern is aligned over the photoresist and transferred thereto via exposure of the mask and the photoresist to light. The exposed portions of the photoresist are then removed, e.g., by etching or other suitable technique. The patterned photoresist is shown generally in Fig. 3f.

The next step 40 comprises removing the exposed portion of the sacrificial layer (shown as 77 in Fig. 3f). For example, if a titanium sacrificial layer is used, the exposed portion thereof is etched using ethylenediamine tetra acetic acid (EDTA) solution. In this manner, the etching exposes the seed layer only at the photoresist openings (see Fig. 3g).

The next step 45 involves electroplating the exposed portion(s) of substrate 64 using conventional electroplating conditions. The electroplated material (shown as 79) forms what will eventually become the electrically-conductive structure (e.g., an electrode). The result of such step is shown generally, e.g., in Fig. 3h. The inventive use of a (titanium) sacrificial layer 76 is advantageous in that, e.g., even if the adhesion of photoresist 72 to substrate 64 via sacrificial layer 76 fails, the remaining portions of the oxidized titanium sacrificial layer 76 tend not to be electroplated during step 45.

Following electroplating step 45, photoresist 72 is stripped or otherwise removed using a conventional dissolution technique or other suitable technique. Fig. 3i shows the result of such processing step. Subsequently, the remaining portions of sacrificial layer 76 are removed (i.e., step 55). It is apparent that such step is unique to embodiments of the invention and are not required in conventional processes of this kind. Step 55 is performed in a conventional manner or other suitable manner, e.g., by a conventional titanium etching technique using EDTA. Fig. 3j shows the result of removing the remaining portions of the sacrificial layer.

The next step 60 involves removing the remaining portions of seed layer 62. Step 60 is performed in a conventional manner or other suitable manner, such as by wet etching. Fig. 3k shows the result of removing the remaining portions of the seed layer.

In addition to the process parameters discussed hereinabove, embodiments of the invention also yield no appreciable underplating under a variety of current density and different bath conditions, thus demonstrating the immunity of the inventive fabrication process to variations that are inherent to electroplating. Experimentation in accordance with embodiments of the invention yield aspect ratios in excess of 5.0 with exceptionally regular structure and nearly vertical walls. More specifically, experimentation in accordance with embodiments of the invention has demonstrated structures having 15-16 pm thick gold features with feature width as narrow as 3.0 µm.

### Example

A portion of a photolithographic method according to embodiments of the invention includes, e.g., the following steps:
a. Vapor deposition of gold seed layer on substrate.
b. Vapor deposition of titanium film sacrificial layer on seed layer.
c. Exposure to ambient air to form non-conductive oxide layer on titanium film sacrificial layer.
d. Vapor deposition of adhesion promoter hexamethyldisilizane (HMDS) on titanium film oxide layer.
e. Application of AZP4620 photoresist (Hoechst Celanese Corp.)
f. Bake at 90° C for 60 minutes in a convection oven.
g. Expose as required according to photoresist thickness.
h. Develop, e.g., 2 minutes in a 3:1 DI water: AZ 400K (Hoechst Celanese Corp.) developer.

Embodiments of the invention are also applicable, e.g., in the fabrication of lithium niobate (LiNbO₃) devices. The poor definition of the traveling wave electrodes has long been a limiting factor on the microwave (attenuation, bandwidth, dielectric constant) performance of LiNbO₃ devices. Problems include the achievable limits on the thickness (11.5 µm) and aspect ratio (1.5 µm) of the gold electrodes. The inconsistency of the microwave characteristics also was associated with poorly defined electrode structure. This inconsistency has made research and design of better microwave performance, slow and inconclusive.

However, fabrication methods employing embodiments of the invention improve lithium niobate device performances to the extent that a reproducible 10% improvement of microwave attenuation is accompanied by about 4 GHz improved -3dB bandwidth (6 GHz to >10 GHz) and more than 8 GHz improvement in the -6dB bandwidth point (12 GHz to >20 GHz). For example, lithium niobate devices with 15-16 µm thick electrodes are possible using a fabrication method according to embodiments of the invention with no underplating being reported. Also, the reproducibility of the electrodes structures has allowed the development and fine tuning of electrode redesigns to optimize the microwave characteristics.

It will be apparent to those skilled in the art that many changes and substitutions can be made to the embodiments of the fabrication methods herein described without departing from the spirit and scope of the invention as defined by the appended claims and their full scope of equivalents. For example, it has been observed that in some applications when the photoresist pattern includes very narrow lines and features, e.g., 3.5-4 µm wide features having a thickness of approximately 5.5 µm, underplating of the gold seed layer under a baked photoresist has occurred. The observed underplating was strongly dependent on the electroplating bath chemistry and the surface morphology of the seed Au film. Methods in accordance with embodiments of the invention eliminate such underplating and thus is useful for suppression of underplating in many different cases where this problem appears.

## Claims

1. A method for fabricating an electrically-conductive structure, said method comprising the steps of:
depositing a seed layer (62) on a substrate (64);
depositing a photoresist (72) on said seed layer;
patterning said photoresist; and
forming said electrically-conductive structures according to said patterned photoresist;
characterized in that the method further comprises, prior to depositing said photoresist, the steps of
depositing a sacrificial layer (76) on said seed layer wherein said sacrificial layer is provided between said seed layer and said photoresist,
removing a portion of said sacrificial layer according to said patterned photoresist, and
forming said electrically-conductive structures according to said removed portion of said sacrificial layer, said sacrificial layer suppressing the tendency of at least one of said photoresist and said seed layer to detach from the other during at least one of said forming, removing and patterning steps, said sacrificial layer having a surface at least a portion of which is non-conductive to said electrically-conductive structure.

2. The method as recited in claim 1, further comprising, prior to the step of applying said photoresist, the step of applying an adhesion promoter to said sacrificial layer, wherein said adhesion promoter is disposed between said sacrificial layer and said photoresist upon depositing said photoresist.

3. The method as recited in claim 2, wherein said adhesion promoter is HMDS.

4. The method as recited in claim 1, further comprising the step of depositing an adhesion layer (66) on at least one of said substrate and seed layer, said adhesion layer having greater adhesion to said substrate and said seed layer than said seed layer has to said substrate and said sacrificial layer has to said seed layer.

5. The method as recited in claim 4, wherein said adhesion layer is chromium (Cr).

6. The method as recited in claim 1, wherein said sacrificial layer is a titanium (Ti) sacrificial layer.

7. The method as recited in claim 1, wherein said further comprising the step of wherein said sacrificial layer depositing step further comprises depositing a first sacrificial layer on said seed layer that adheres to said seed layer and depositing a second sacrificial layer that adheres to said first sacrificial layer.

8. The method as recited in claim 1, further comprising, after the step of depositing said sacrificial layer and prior to the step of depositing said photoresist, the step of exposing said sacrificial layer to ambient air, wherein a portion of the surface of said sacrificial layer oxidizes thereby forming an oxide layer.

9. The method as recited in claim 1, wherein said sacrificial layer has a thickness of approximately 200 to approximately 700 Angstroms.
